# EUROPEAN PATENT APPLICATION

(11) **EP 4 016 617 A1**
(43) Date of publication of application: **22.06.2022**
(21) Application number: 21215210.2
(22) Date of filing: 16.12.2021
(51) Int. Cl.: H01L 23/498, H01L 23/495

(54) **METHOD OF MANUFACTURING SEMICONDUCTOR DEVICES, COMPONENT FOR USE THEREIN AND CORRESPONDING SEMICONDUCTOR DEVICE**

(30) Priority: 18.12.2020 IT 202000031553
(71) Applicant: STMicroelectronics S.r.l., 20864 Agrate Brianza (MB) (IT)
(72) Inventor: MAZZOLA, Mauro, I-24040 Calvenzano (Bergamo) (IT); TIZIANI, Roberto, I-20014 Nerviano (Milano) (IT)
(74) Representative: Bosotti, Luciano

(57) **Abstract**

In a method of manufacturing semiconductor devices, one or more semiconductor chips are arranged at a semiconductor chip mounting area (14) in a first surface of a leadframe (10).

The leadframe comprises a pattern of electrically-conductive formations (12, 14, 14', 14") with one or more sacrificial connection formations (100) extending bridge-like between a pair of electrically-conductive formations (14, 14'). The sacrificial connection formation or formations (100) are formed at one of the first surface and the second surface of the leadframe (10) and have a thickness less than the leadframe thickness between the first surface and the second surface. A filling of electrically-insulating material (16) is molded between the electrically-conductive formations of the leadframe, with electrically-insulating material molded between the connection formation(s) and the other surface of the leadframe (10). The sacrificial connection formation(s) counter deformation and displacement of parts during formation and pre-molding of the leadframe (10).

## Description

### Technical field

The description relates to semiconductor devices.

One or more embodiments may be applied to semiconductor devices such as integrated circuits (ICs), for instance.

### Technological background

Various types of semiconductor devices may benefit from using pre-molded leadframes.

Quad Flat No-leads (QFN) packages having peripheral lands at the package bottom in order to provide electrical connection to a substrate such as a printed circuit board (PCB) are exemplary of such devices.

A pre-molded leadframe includes resin/plastic material around the metal leads and the pads/paddles onto which semiconductors chips or dice are attached; a molding compound (epoxy resin, for instance) is subsequently molded onto the chips or dice attached onto the pre-molded leadframe.

In the case of a QFN package, for instance, a metal (e.g., copper) leadframe is etched top and bottom using photoetching technology in order to produce a desired pattern of one or more pads/paddles together with leads connected to a bar.

The leadframe thus etched is completely filled with plastic resin during a pre-molding step. This can involve using standard molding technology in order to fill the empty spaces in the leadframe.

After molding, deflashing and smearing processes can be applied in order to obtain clean top and bottom copper surfaces, with the pre-mold resin encapsulating the parts of the leadframe in a stable planar structure.

During the (pre)molding process, resin flows through the open spaces to permeate the leadframe thickness. The structures in the leadframe should maintain a desired position to avoid any displacement or deformation during filling.

To that effect, parts of the leadframe such as the pads can be supported/fixed via connection bars. These connection bars may be located, for instance, at pad corners in order to save space and leave remaining space available for signal leads.

If, for instance, two or more pads/paddles are present in the leadframe, reliably "locking" all of them via multiple connections is hardly feasible. It is observed that pads or paddles with (only) two connections can undesirably move during molding.

In the case of complex designs with a higher number of pads/paddles, providing adequate connections to the outer bars becomes practically impossible. For instance, in circuit layouts including discrete components, die pads connected by bars may not be electrically insulated as desired, with drains and collectors commonly shorted, for instance.

Also, locations used to form additional connection bars consume valuable area and may result in certain lead in the leadframe becoming unavailable and thus lost.

To sum up, such conventional approaches in dealing with undesired displacement or deformation during pre-molding, with an ensuing risk of loss of electrical insulation between frame fixtures, suffer from drawbacks such as:
possible decrease in pin count and a increase in package size,
design constraints in case of multiple die pads,
die pads electrically shorted.

### Object and summary

An object of one or more embodiments is to contribute in providing improved solutions overcoming drawbacks of prior art solutions as discussed in the foregoing.

According to one or more embodiments, such an object can be achieved via a method having the features set forth in the claims that follow.

One or more embodiments may relate to a component for use in such a method. A pre-molded leadframe comprising half-etched temporary connection bars between pads may be exemplary of such a component.

One or more embodiments may relate to a corresponding semiconductor device which can be produced using such a component.

The claims are an integral part of the technical disclosure provided herein in connection with the embodiments.

One or more embodiments may involve temporary (sacrificial) connections, which are half-etched on the bottom (or back) side of the leadframe. These connections contribute in keeping the leadframe structure together during etching and pre-molding, reducing the risk of deformation and undesired displacement.

In one or more embodiments, die pads can be only temporarily shorted and physical separation can be obtained during an etching step where the connecting bars are removed.

One or more embodiments effectively reduce deformation and facilitate stronger leadframe stability during pre-molding, saving space for additional pads.

One or more embodiments do not negatively affect package size and/or the number of signal leads available; plural pads/paddles can be accommodated with no design constraints.

### Brief description of the several views of the drawings

One or more embodiments will now be described, by way of example only, with reference to the annexed figures, wherein:
Figures 1A and 1B are perspective views of a leadframe according to embodiments of the present description prior to pre-molding;
Figures 2A and 2B are perspective views of a leadframe according to embodiments of the present description after pre-molding;
Figure 3 is a cross sectional view along line II-II of Figure 2B reproduced on an enlarged scale;
Figure 4 is a cross sectional view substantially corresponding to the view Figure 3 showing the result of an etching step; and
Figures 5A and 5B are perspective views of a semiconductor device to which embodiments of the present description may apply.

It will be appreciated that, for the sake of clarity and ease of understanding, the various figures may not be drawn to a same scale.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular conformations, structures, or characteristics may be combined in any adequate way in one or more embodiments.

The headings/references used herein are provided merely for convenience and hence do not define the extent of protection or the scope of the embodiments.

Also, throughout the figures, like parts or elements are indicated with like reference symbols, and a corresponding description will not be repeated for each and every figure for brevity.

The designation leadframe (or lead frame) is currently used (see, for instance the USPC Consolidated Glossary of the United States Patent and Trademark Office) to indicate a metal frame which provides support for a semiconductor chip or die as well as electrical leads to couple the semiconductor chip or die to other electrical components or contacts.

Essentially, a leadframe comprises an array of electrically-conductive formations (leads) which from a peripheral location extend inwardly in the direction of the semiconductor chip or die, thus forming an array of electrically-conductive formations from the die pad having at least one semiconductor chip or die attached thereon. This may be via a die attach adhesive (a die-attach film or DAF, for instance).

Electrical coupling of the leads in the lead frame with the semiconductor chip or die may be via wires forming a wire-bonding pattern around the chip or die.

The leadframe together with the semiconductor die or dice (currently referred to also as semiconductor chip or chips) mounted thereon is one of the main parts of the plastic package of a semiconductor device. It is made of electrically-conductive material (metal such as copper, for instance) and configured and shaped to support the die or dice attached thereon using different interposed material: glue, tape, solder paste.

Various types of semiconductor devices may benefit from using pre-molded leadframes. A pre-molded leadframe includes resin/plastic material around the metal leads and the die paddles onto which semiconductors chips or dice can be attached; a molding compound (epoxy resin, for instance) is subsequently molded onto the chips or dice attached onto the pre-molded leadframe.

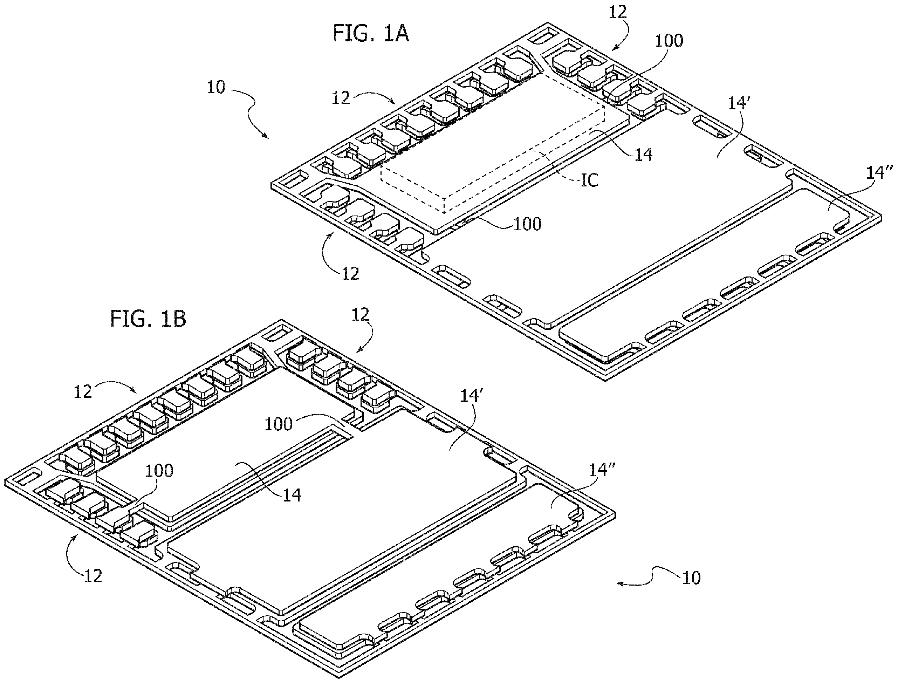

Figures 1A and 1B are perspective views of a "naked" leadframe 10 (prior to pre-molding) observed: in Figure 1A, from the top or front side (the one onto which the semiconductor die or dice are mounted), and

in Figure 1B, from the bottom or back side.

As illustrated (merely by way of example) in Figures 1A and 1B, the leadframe 10 may include an array of leads 12 and at least one die pad 14 onto which one (or more) semiconductor chips IC (shown in dashed outline) can be mounted.

As illustrated herein by way of example, the leadframe 10 (for use in a semiconductor device such as an electronic fuse - briefly e-fuse of eFuse, for example) may include other pads or paddles 14', 14" configured to be coupled to (power) connections such as so-called ribbons for the semiconductor chip or chips IC (shown in dashed outline).

Those of skill in the art will easily appreciate that the description provided herein in connection with the die pad 14 also applies to pads or paddles such as 14' and/or 14".

A conventional technology used to produce a leadframe such as 10 is photoetching. Raw (e.g. copper) panels or reels are covered top/bottom with resist that is developed by masking and etched. Metal exposed is etched away and the resist eventually removed. Both leads 12 and pads/paddles 14, 14', and 14" can be formed simultaneously with this technology.

Semiconductor dice such as IC in the figures are attached to the pads such as 14 and gold, silver or copper wires (not visible in the figures for simplicity) are provided during a wire-bonding process in order to connect the die/dice with the leads/pads. After wire bonding, encapsulation/solder plating steps complete the packaging flow.

In those types of semiconductor devices using pre-molded leadframes, the "naked" leadframe of Figure 1A and 1B is subjected to pre-molding processing which results in the leadframe 10 being turned into a pre-molded leadframe.

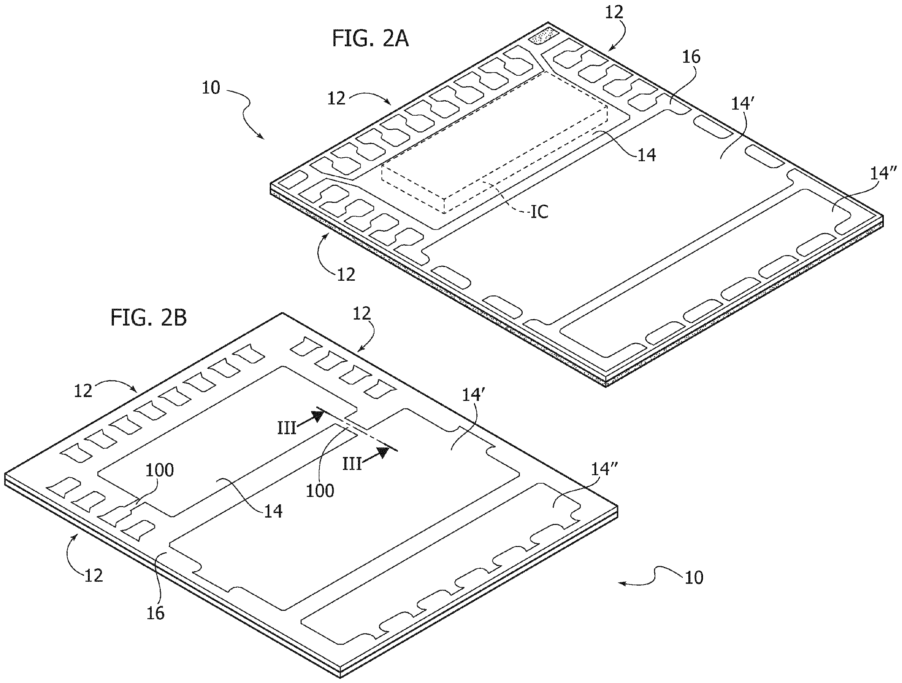

As visible in Figures 2A and 2B, namely:
in Figure 2A, with the pre-molded leadframe 10 observed from the top or front side, and
in Figure 2B, with the pre-molded leadframe 10 observed from the bottom or back side,
a pre-molded leadframe 10 is "full-filled" with resin/plastic material 16 (epoxy resin, for instance) caused to penetrate into (and undergo solidification in) the spaces around the metal leads 12 and the pads or paddles 14, 14', 14".

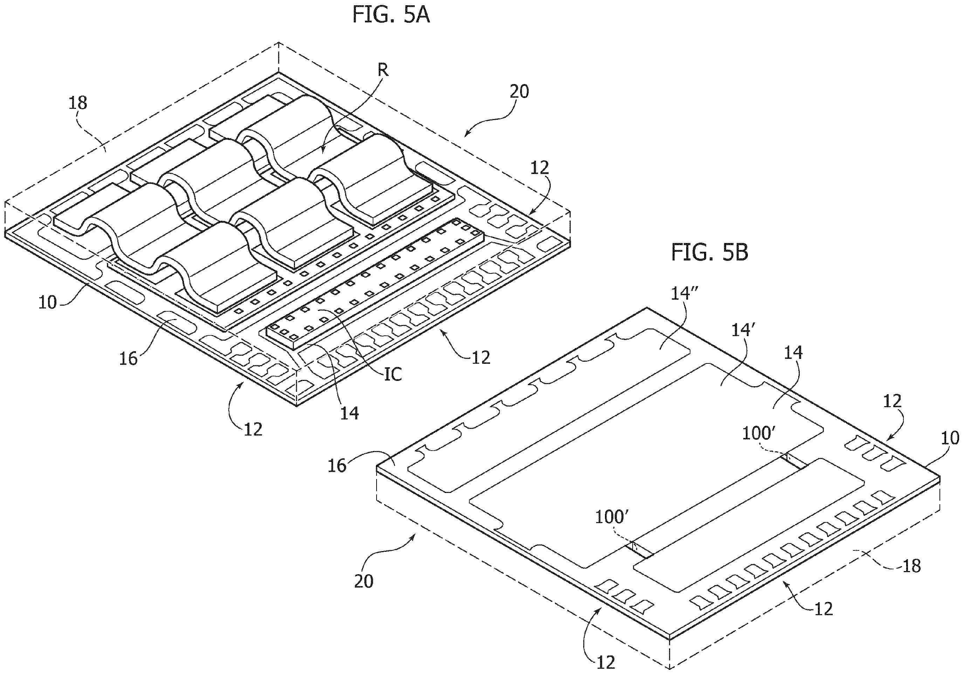

A molding compound is subsequently molded onto the (pre-molded) leadframe 10 having chips or dice 14 attached thereon. Such a molding compound (epoxy resin, for instance, different or identical to the pre-mold resin 16) is not visible in Figure 2A for simplicity but is represented in dashed outline as 18 in Figures 5A and 5B as discussed in the following.

In general terms, pre-molded leadframe technology as discussed in the foregoing is conventional in the art, which makes it unnecessary to provide a more detailed description herein.

During the pre-molded leadframe manufacturing process (see Figures 2A and 2B in comparison with Figures 1A and 1B) the etched leadframe is fully filled by resin such as 16 which penetrates into the empty spaces through the thickness of a naked leadframe as illustrated in Figure 1A and 1B.

As noted, the various structures (leads 12, pads or paddles 14, 14', 14", including die pads 14) should desirably retain their position with displacement or deformation avoided during leadframe formation and during filling by the pre-mold resin.

In one or more embodiments, temporary (sacrificial) connections may be provided as exemplified at 100 in Figures 1A, 1B and 2B. As illustrated, these connections can be provided, for instance, between a paddle or pad and another paddle or pad and between a paddle or pad and a lead. At least in principle, also inter-lead connections can be considered.

In one or more embodiments, the connections 100 can be provided as half-etched formations at the bottom or back side of the leadframe during the etching process which leads to producing the "naked" leadframe 10 of Figures 1A and 1B.

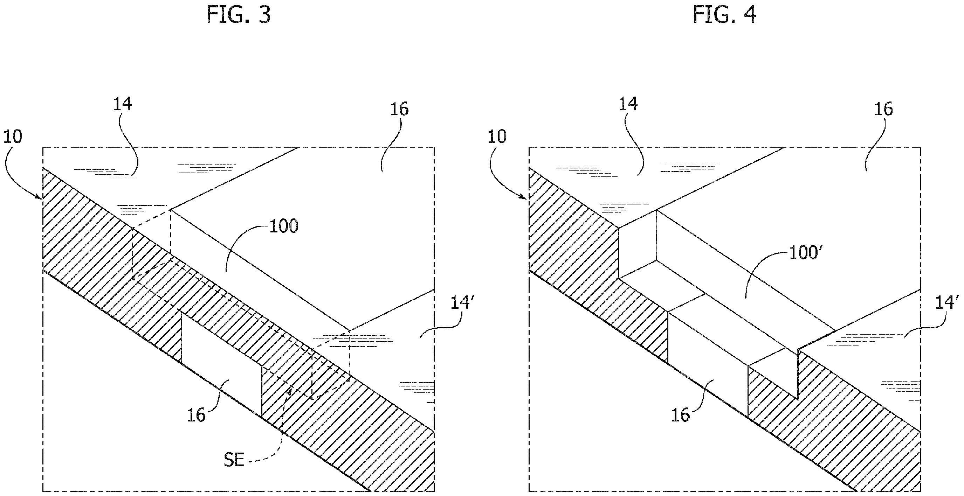

As visible in the cross-sectional view of Figure 3, the connections 100 extend bridge-like between two electrically conductive portions (the die pad 14 and the neighboring paddle 14', in the case exemplified in Figure 3) being half-etched in the lead frame 10, without extending over the whole depth or height of the lead frame 10.

That is, as visible in Figure 3 (where the leadframe is shown bottom-side-up, namely observed from its bottom or back side) a certain amount of pre-mold resin 16 remains between the connection 100 (essentially a bar) and the top or front side of the lead frame (facing downwards in Figure 3).

According to current language in the art, the designation "half-etched" is used herein to denote connections 100 that do not extend over the whole depth or height of the leadframe 10 (as measured between the opposed surfaces of the leadframe 10), without this implying that the connections 100 should have by way of necessity a thickness/height equal or in the vicinity of 50% the thickness/height of the leadframe 10.

Depending on the applications/processes, the thickness/height of the connections 100 can be chosen in order to facilitate subsequent removal of the connections 100 (as schematically illustrated in dashed lines at SE in Figure 3).

As illustrated in Figure 4, removal (etching, for instance) of a connection 100 results in a recess being formed at the location where the connection 100 was provided.

Removal of the connections 100 may involve, for instance, a (further) etching step of the leadframe 10.

Such (selective) etching - as indicated by SE in Figure 3 - may be applied to the leadframe 10 also for other purposes which are of no specific interest for the features of the embodiments discussed herein.

As discussed, the connections 100 facilitate keeping the leadframe structure firmer and stronger during formation of the leadframe 10 (by etching, for instance) as well as during pre-molding, reducing the risk of undesired deformation and displacement of parts.

As can be appreciated comparing Figure 3 and Figure 4, removal of the connections 100 re-establishes electrical isolation between adjacent electrically-conductive portions of the leadframe (as exemplified by the die pad 14 and the paddle 14' in Figures 3 and 4) which were previously connected (mechanically and electrically) by the connections 100.

Figures 5A and 5B are perspective views of a semiconductor device 20 (an electronic fuse - briefly an e-fuse or eFuse) including a pre-molded leadframe 10 processed as discussed in the foregoing. Specifically, Figure 5A illustrates the device 20 observed from the top or front side and Figure 5B illustrates the device 20 observed from the bottom or back side.

As illustrated herein by way of example, the leadframe 10 may include other pads or paddles 14', 14" configured to be receive (power) connections such as so-called ribbons or clips R coupled to the semiconductor chip or chips IC (shown in dashed outline).

A molding compound 18 is molded onto the (pre-molded) leadframe 10 having the chip(s) IC and electrical contacts (ribbons) R arranged thereon at the top or front surface, facing upward in Figure 5A. The outline of the molding compound 18 (epoxy resin, for instance, different or identical to the pre-mold resin 16) is represented in dashed outline in Figures 5A and 5B.

Of course, reference to an electronic fuse as a semiconductor device 20 to which embodiments may apply is merely by way of example and is not to be construed in a limiting sense of the embodiments.

The representation of Figure 5B with the bottom or back surface of the leadframe 10 facing upward shows possible "residues" 100' of the removal of the connections 100 which remain in the final device 20.

Residues 100' of two connections between the pads/paddles 14 and 14' are exemplified in Figure 5B, being otherwise understood that such residues may be present at any location where the ("half-etched") connections 100 were originally present and subsequently removed.

These residues 100' may include notches or recesses in the bottom or back surface of the leadframe 12 (and the device 20) at those locations where the connections 100 were originally provided, with these connections subsequently removed ("etched out", for instance) to provide electrical insulation between electrically-conductive structures of the leadframe 10, such as 14 and 14' in Figures 3 and 4.

It is noted that in certain embodiments, residues 100' may include notches or recesses which are subsequently at least partly filled by other materials such as plating.

In any case the residues 100' remain and their presence can be detected in a final complete device as "testimonials" of the provision and subsequent removal of the connections 100, that is as evidence of connection removal.

As illustrated in Figure 4, the residues 100' may include mutually protruding portions of the conductive structures of the leadframe 10, such as 14 and 14' which originally acted as end abutments of the bridge-like structure of the connection 100.

One or more embodiments thus effectively reduce undesired deformation and displacement of a leadframe during formation thereof (via etching, for instance) and during pre-molding, while saving space for additional pads/paddles and signal leads, with no particular constraints in design, facilitating manufacturing of smaller packages.

To sum up, one or more embodiments may concern a method of manufacturing semiconductor devices (for instance, 20), wherein the method comprises:
arranging at least one semiconductor chip (for instance, IC) onto at least one semiconductor chip mounting area (for instance, the die mounting pad 14) in a first (top or front, for instance) surface of a leadframe (for instance, 10), the leadframe comprising a pattern of electrically-conductive formations (for instance, leads 12 and pads/paddles 14, 14', 14") and having a second (bottom or back, for instance) surface opposite the first surface and a leadframe thickness between the first surface and the second surface (that is, measured in a direction normal to the general plane of the leadframe).

A method as exemplified herein may comprise:
forming (providing) at least one (sacrificial) connection formation (for instance, 100) extending bridge-like between a pair of electrically-conductive formations (see, for instance, 14, 14' in Figure 3) in said pattern of electrically-conductive formations, wherein the at least one connection formation is formed at one of the first surface and the second surface of the leadframe (for instance, at the first surface) and has a thickness less than said leadframe thickness between the first surface and the second surface,
molding a filling of electrically-insulating material (for instance, 16) between electrically-conductive formations in said pattern of electrically-conductive formations, with electrically-insulating material from said filling molded (and thus penetrating) between said at least one connection formation and the other of the first surface and the second surface (for instance, the second surface) of the leadframe
eliminating (see, for instance, SE in Figure 3) said at least one (sacrificial) connection formation between said pair of electrically-conductive formations in said pattern of electrically-conductive formations.

A method as exemplified herein may comprise forming the at least one connection formation at the second (for instance, bottom or back) surface of the leadframe.

A method as exemplified herein may comprise forming or providing (for instance, via etching) the at least one connection formation together with said pattern of electrically-conductive formations in the leadframe.

A method as exemplified herein may comprise forming (providing) the at least one connection formation and said pattern of electrically-conductive formations by etching metal material.

A method as exemplified herein may comprise forming (providing) the at least one connection formation with a thickness approximately half said leadframe thickness between the first surface and the second surface.

As used herein, the wording "approximately" denotes a technical feature being produced within the technical tolerance of the method used to manufacture it.

A leadframe (such as 10, for instance) as exemplified herein lends itself to being supplied as a component for use in a method as exemplified herein.

Such a component may be provided as a "naked" (e.g., metal-only) leadframe as exemplified in Figures 1A and 1B having a first surface including at least one semiconductor chip mounting area (for instance, 14) and a second surface opposite the first surface, the leadframe having a leadframe thickness between the first surface and the second surface, wherein the leadframe comprises:
a pattern of electrically-conductive formations (for instance, 12, 14, 14', 14"),
at least one connection formation (for instance, 100) extending bridge-like between a pair of electrically-conductive formations (for instance, 14, 14') in said pattern of electrically-conductive formations, wherein the at least one connection formation is located at one of the first surface and the second surface (for instance, at the first surface) of the leadframe and has a thickness less than said leadframe thickness between the first surface and the second surface.

Advantageously, the at least one connection formation may be located at the second surface of the leadframe (10).

Advantageously, the at least one connection formation may have a thickness approximately half said leadframe thickness between the first surface and the second surface of the leadframe.

Here again, the wording "approximately" denotes a technical feature being produced within the technical tolerance of the method used to manufacture it.

A component as discussed herein may be likewise supplied as a "pre-molded" (e.g. metal plus pre-mold resin) leadframe as exemplified in Figures 2A and 2B, comprising a filling of electrically-insulating material (for instance, 16) molded between electrically-conductive formations in said pattern of electrically-conductive formations, with electrically-insulating material from said filling molded between said at least one connection formation and the other of the first surface and the second surface (for instance, the bottom or back surface) of the leadframe (10).

A semiconductor device (see, for instance, 20 in Figures 5A and 5B) as exemplified herein may comprise:
at least one semiconductor chip (for instance, IC) arranged onto at least one semiconductor chip mounting area (for instance, 14) in a first (for instance, top or front) surface of a leadframe, the leadframe comprising a pattern of electrically-conductive formations and having a second surface opposite the first surface and a leadframe thickness between the first surface and the second surface,
a filling of electrically-insulating material (for instance, 16) molded between electrically-conductive formations in said pattern of electrically-conductive formations, and
at least one recess (for instance, 100') at one of the first surface and the second surface (for instance, the bottom or back surface) of the leadframe, the at least one recess extending bridge-like between a pair of electrically-conductive formations (see for instance, 14, 14' in Figure 4) in said pattern of electrically-conductive formations, wherein the at least one recess (which results from eliminating a connection such as 100) has a depth less than said leadframe thickness between the first surface and the second surface and said pair of electrically-conductive formations in said pattern of electrically-conductive formations are mutually electrically insulated at said recess.

In a semiconductor device as exemplified herein, the at least one recess (for instance, 100') may be located at the second surface of the leadframe.

Without prejudice to the underlying principles, the details and the embodiments may vary, even significantly, with respect to what has been described by way of example only without departing from the scope of the embodiments.

The extent of protection is determined by the annexed claims.

## Claims

1. A method, comprising:
arranging at least one semiconductor chip (IC) onto at least one semiconductor chip mounting area (14) in a first surface of a leadframe (10), the leadframe comprising a pattern of electrically-conductive formations (12, 14, 14', 14") and having a second surface opposite the first surface and a leadframe thickness between the first surface and the second surface,
wherein the method comprises:
forming at least one connection formation (100) extending bridge-like between a pair of electrically-conductive formations (14, 14') in said pattern of electrically-conductive formations (12, 14, 14', 14"), wherein the at least one connection formation (100) is formed at one of the first surface and the second surface of the leadframe (10) and has a thickness less than said leadframe thickness between the first surface and the second surface,
molding a filling of electrically-insulating material (16) between electrically-conductive formations (12, 14, 14', 14") in said pattern of electrically-conductive formations (12, 14, 14', 14"), with electrically-insulating material (16) from said filling molded between said at least one connection formation (100) and the other of the first surface and the second surface of the leadframe (10), and
eliminating (SE) said at least one connection formation (100) between said pair of electrically-conductive formations (14, 14') in said pattern of electrically-conductive formations (12, 14, 14', 14").

2. The method of claim 1, wherein the method comprises forming the at least one connection formation (100) at the second surface of the leadframe (10).

3. The method of claim 1 or claim 2, wherein the method comprises forming the at least one connection formation (100) together with said pattern of electrically-conductive formations (12, 14, 14', 14") in the leadframe.

4. The method of any of claims 1 to 3, wherein the method comprises forming the at least one connection formation (100) and said pattern of electrically-conductive formations (12, 14, 14', 14") by etching metal material.

5. The method of any of the previous claims, comprising forming the at least one connection formation (100) with a thickness approximately half said leadframe thickness between the first surface and the second surface.

6. A leadframe (10) for use in the method of any of claims 1 to 5, the leadframe having a first surface including at least one semiconductor chip mounting area (14) and a second surface opposite the first surface, the leadframe (10) having a leadframe thickness between the first surface and the second surface, wherein the leadframe (10) comprises:
a pattern of electrically-conductive formations (12, 14, 14', 14"),
at least one connection formation (100) extending bridge-like between a pair of electrically-conductive formations (14, 14') in said pattern of electrically-conductive formations (12, 14, 14', 14"), wherein the at least one connection formation (100) is located at one of the first surface and the second surface of the leadframe (10) and has a thickness less than said leadframe thickness between the first surface and the second surface.

7. The leadframe (10) of claim 6, wherein the at least one connection formation (100) is located at the second surface of the leadframe (10).

8. The leadframe (10) of claim 6 or claim 7, wherein the at least one connection formation (100) has a thickness approximately half said leadframe thickness between the first surface and the second surface of the leadframe (10).

9. The leadframe (10) of any of claims 6 to 8, comprising a filling of electrically-insulating material (16) molded between electrically-conductive formations (12, 14, 14', 14") in said pattern of electrically-conductive formations (12, 14, 14', 14"), with electrically-insulating material (16) from said filling molded between said at least one connection formation (100) and the other of the first surface and the second surface of the leadframe (10),

10. A semiconductor device (20), comprising:
at least one semiconductor chip (IC) arranged onto at least one semiconductor chip mounting area (14) in a first surface of a leadframe (10), the leadframe comprising a pattern of electrically-conductive formations (12, 14, 14', 14") and having a second surface opposite the first surface and a leadframe thickness between the first surface and the second surface,
a filling of electrically-insulating material (16) molded between electrically-conductive formations (12, 14, 14', 14") in said pattern of electrically-conductive formations (12, 14, 14', 14"), and
at least one recess (100') at one of the first surface and the second surface of the leadframe (10), the at least one recess (100') extending bridge-like between a pair of electrically-conductive formations (14, 14') in said pattern of electrically-conductive formations (12, 14, 14', 14"), wherein the at least one recess (100') has a depth less than said leadframe thickness between the first surface and the second surface and said pair of electrically-conductive formations (14, 14') in said pattern of electrically-conductive formations (12, 14, 14', 14") are mutually electrically insulated at said recess (100').

11. The semiconductor device (20) of claim 10, wherein the at least one recess (100') is located at the second surface of the leadframe (10).
